# EUROPEAN PATENT APPLICATION

(11) **EP 4 391 780 A1**
(43) Date of publication of application: **26.06.2024**
(21) Application number: 22880873.9
(22) Date of filing: 04.10.2022
(51) Int. Cl.: H10N 10/855, H10N 10/856, H10N 10/01

(54) **THERMOELECTRIC CONVERSION ELEMENT AND METHOD FOR PRODUCING SAME**

(30) Priority: 12.10.2021 JP 2021167381
(71) Applicant: Denka Company Limited, Tokyo 103-8338 (JP)
(72) Inventor: SAKURAI, Yasuaki, Tokyo 103-8338 (JP); ASAMI, Takeshi, Tokyo 103-8338 (JP); NIWA, Ryota, Tokyo 103-8338 (JP)
(74) Representative: Mewburn Ellis LLP
(86) International application number: PCT/JP2022/037167
(87) International publication number: WO 2023/063177

(57) **Abstract**

There is provided a thermoelectric conversion element having a p-type thermoelectric conversion layer containing a p-type material containing carbon nanotubes and a conductive resin, and an n-type thermoelectric conversion layer that is in contact with the p-type thermoelectric conversion layer and contains an n-type material obtained by doping the p-type material containing carbon nanotubes and a conductive resin with a dopant, wherein the dopant contains an anion that is a complex ion, an alkali metal cation, and a cation scavenger.

## Description

### Technical Field

The present invention relates to a thermoelectric conversion element and a method for producing the same.

### Background Art

Thermoelectric conversion is a technology for directly converting heat into electricity using the Seebeck effect, and has been receiving attention as an energy recovery technology for converting waste heat and the like generated when using fossil fuels into electricity.

In the related art, inorganic materials have been mainly considered as thermoelectric conversion materials, but they have problems such as being difficult to install on curved surfaces, use of rare elements or toxic elements, and being unsuitable for installation over large areas.

Thus, in recent years, organic materials have been focused upon as thermoelectric conversion materials in order to address the above problems (for example, Patent Literature 1 to 3).

### Citation List

### Patent Literature

[Patent Literature 1] Japanese Unexamined Patent Publication No. 2013-98299
[Patent Literature 2] Japanese Unexamined Patent Publication No. 2003-332638
[Patent Literature 3] Japanese Unexamined Patent Publication No. 2000-323758

### Summary of Invention

### Technical Problem

An object of the present invention is to provide a thermoelectric conversion element with a low element resistance and a high output and a method for producing the same.

### Solution to Problem

One aspect of the present invention relates to, for example, the following [1] to [8].
[1] A thermoelectric conversion element having:
   a p-type thermoelectric conversion layer containing a p-type material containing carbon nanotubes and a conductive resin; and
   an n-type thermoelectric conversion layer that is in contact with the p-type thermoelectric conversion layer and contains an n-type material obtained by doping the p-type material containing carbon nanotubes and a conductive resin with a dopant,
   wherein the dopant contains an anion that is a complex ion, an alkali metal cation, and a cation scavenger.
[2] The thermoelectric conversion element according to [1],
   wherein the anion is selected from the group consisting of a ferrocyanide ion, ferricyanide ion, a tetrachloroferrate(III) ion and a tetrachloroferrate(II) ion.
[3] The thermoelectric conversion element according to [1] or [2],
   wherein the cation scavenger is a crown ether compound.
[4] The thermoelectric conversion element according to any one of [1] to [3],
   wherein the cation scavenger is a crown ether compound having a benzene ring in the molecule.
[5] The thermoelectric conversion element according to any one of [1] to [4],
   wherein the conductive resin is composed of poly(3,4-ethylenedioxythiophene) and an electron acceptor.
[6] The thermoelectric conversion element according to any one of [1] to [5],
   wherein the p-type thermoelectric conversion layer and the n-type thermoelectric conversion layer have a thickness of 1 to 500 µm.
[7] A method for producing a thermoelectric conversion element having a p-type thermoelectric conversion layer and an n-type thermoelectric conversion layer, including
   a process of doping a part of a p-type material layer containing a p-type material containing carbon nanotubes and a conductive resin with a dopant,
   wherein the p-type thermoelectric conversion layer contains the p-type material,
   wherein the n-type thermoelectric conversion layer contains an n-type material obtained by doping the p-type material with the dopant, and
   wherein the dopant contains an anion that is a complex ion, an alkali metal cation, and a cation scavenger.
[8] The method according to [7],
   wherein the process includes
   an impregnation process of impregnating a part of the p-type material layer with a dopant solution containing the dopant and a solvent, and
   a solvent removal process of removing at least a part of the solvent.

### Advantageous Effects of Invention

According to the present invention, there are provided a thermoelectric conversion element with a low element resistance and a high output and a method for producing the same.

### Brief Description of Drawings

FIG. 1(a) is a top view showing one aspect of a thermoelectric conversion element, and FIG. 1(b) is a cross-sectional view showing the Ib-Ib cross section in FIG. 1(a).
FIG. 2(a) is a top view showing another aspect of the thermoelectric conversion element and FIG. 2(b) is a cross-sectional view showing the IIb-IIb cross section in FIG. 2(a).
FIG. 3(a) is a top view showing a thermoelectric conversion element of Comparative Example 1, and FIG. 3(b) is a cross-sectional view showing the IIIb-IIIb cross section in FIG. 3(a).

### Description of Embodiments

Hereinafter, preferable embodiments of the present invention will be described in detail.

### (Thermoelectric conversion element)

The thermoelectric conversion element of the present embodiment includes a p-type thermoelectric conversion layer and an n-type thermoelectric conversion layer that is in contact with the p-type thermoelectric conversion layer. The p-type thermoelectric conversion layer is a layer containing a p-type material containing carbon nanotubes and a conductive resin. In addition, the n-type thermoelectric conversion layer is a layer containing an n-type material obtained by doping the p-type material containing carbon nanotubes and a conductive resin with a dopant. In addition, the dopant contains an anion that is a complex ion, an alkali metal cation, and a cation scavenger.

The thermoelectric conversion element of the present embodiment has a low element resistance and a high output. The reason why such effects are exhibited is not entirely clear, but it is speculated that, in the thermoelectric conversion element of the present embodiment, since both the p-type thermoelectric conversion layer and the n-type thermoelectric conversion layer are formed based on a p-type material containing carbon nanotubes and a conductive resin, the p-type thermoelectric conversion layer and the n-type thermoelectric conversion layer have favorable affinity, and an increase in element resistance due to the layer interface can be avoided.

### <p-type material>

The p-type material contains carbon nanotubes (CNT) and a conductive resin.

The carbon nanotubes may be single-walled, double-walled or multi-walled carbon nanotubes, and single-walled carbon nanotubes are preferable in order to further improve electrical conductivity.

The carbon nanotubes preferably include single-walled carbon nanotubes. The content of the single-walled carbon nanotubes with respect to the total amount of the carbon nanotubes is, for example, preferably 25 mass% or more, more preferably 50 mass% or more, and may be 100 mass%.

The diameter of the single-walled carbon nanotubes is not particularly limited, and may be, for example, 20 nm or less, and is preferably 10 nm or less, and more preferably 3 nm or less. Here, the lower limit of the diameter of the single-walled carbon nanotubes is not particularly limited, and may be, for example, 0.4 nm or more, or 0.5 nm or more. That is, the diameter of the single-walled carbon nanotubes may be, for example, 0.4 to 20 nm, 0.4 to 10 nm, 0.4 to 3 nm, 0.5 to 20 nm, 0.5 to 10 nm or 0.5 to 3 nm.

In this specification, the diameter of the single-walled carbon nanotubes can be determined from the wavenumber (ω(cm⁻¹)) of a peak appearing at 100 to 300 cm⁻¹ by Raman spectroscopy, using the formula of diameter (nm)=248/ω.

As a method for evaluating single-walled carbon nanotubes, the G/D ratio in laser Raman spectroscopy is known. In the present embodiment, the G/D ratio of the single-walled carbon nanotubes in laser Raman spectroscopy at a wavelength of 532 nm is preferably 10 or more and more preferably 20 or more. When such single-walled carbon nanotubes are used, thermoelectric conversion materials with better electrical conductivity tend to be obtained. Here, the upper limit of the G/D ratio is not particularly limited, and the G/D ratio may be, for example, 500 or less, or 300 or less. That is, the G/D ratio may be, for example, 10 to 500, 10 to 300, 20 to 500 or 20 to 300.

The content of the carbon nanotubes based on the total amount of the p-type material may be, for example, 20 mass% or more, and is preferably 30 mass% or more, and more preferably 40 mass% or more. In addition, the content of the carbon nanotubes based on the total amount of the p-type material may be, for example, 99 mass% or less, and is preferably 95 mass% or less, and more preferably 90 mass% or less. That is, the content of the carbon nanotubes based on the total amount of the p-type material may be, for example, 20 to 99 mass%, 20 to 95 mass%, 20 to 90 mass%, 30 to 99 mass%, 30 to 95 mass%, 30 to 90 mass%, 40 to 99 mass%, 40 to 95 mass% or 40 to 90 mass%.

The conductive resin is not particularly limited, and any known conductive resin used for thermoelectric conversion materials can be used without particular limitations. Examples of conductive resins include polyaniline-based conductive polymers, polythiophene-based conductive polymers, polypyrrole-based conductive polymers, polyacetylene-based conductive polymers, polyphenylene-based conductive polymers, and polyphenylene vinylene-based conductive polymers. Examples of polythiophene-based conductive polymers include poly(3,4-ethylenedioxythiophene).

The conductive resin is preferably a conductive resin composed of poly(3,4-ethylenedioxythiophene) (hereinafter sometimes referred to as PEDOT) and an electron acceptor. When such a conductive resin is used, electrical conductivity tends to be further improved.

Examples of electron acceptors include polystyrene sulfonic acid, polyvinyl sulfonic acid, poly(meth)acrylic acid, polyvinyl sulfonic acid, toluene sulfonic acid, dodecylbenzenesulfonic acid, camphorsulfonic acid, bis(2-ethylhexyl) sulfosuccinate, chlorine, bromine, iodine, phosphorous pentafluoride, arsenic pentafluoride, boron trifluoride, hydrogen chloride, sulfuric acid, nitric acid, tetrafluoroboric acid, perchloric acid, iron(III) chloride, and tetracyanoquinodimethane. In order to further improve electrical conductivity, the electron acceptor is preferably polystyrene sulfonic acid (hereinafter sometimes referred to as PSS).

The content of the conductive resin based on the total amount of the p-type material may be, for example, 1 mass% or more, and is preferably 5 mass% or more, and more preferably 10 mass% or more. In addition, the content of the conductive resin based on the total amount of the p-type material may be, for example, 80 mass% or less, and is preferably 70 mass% or less, and more preferably 60 mass% or less. That is, the content of the conductive resin based on the total amount of the p-type material may be, for example, 1 to 80 mass%, 1 to 70 mass%, 1 to 60 mass%, 5 to 80 mass%, 5 to 70 mass%, 5 to 60 mass%, 10 to 80 mass%, 10 to 70 mass% or 10 to 60 mass%.

The total content of the carbon nanotubes and the conductive resin in the p-type material based on the total amount of the p-type material may be, for example, 80 mass% or more, and is preferably 90 mass% or more, more preferably 95 mass% or more, and may be 99 mass% or more, or 100 mass%.

The p-type material may further contain components other than those described above. Examples of other components include a residual solvent, a carbon-based conductive material, an inorganic conductive material, an inorganic thermoelectric material, a binder resin, a surfactant, an antifoaming agent, a coupling agent, an antioxidant, an ultraviolet absorber, a viscosity modifier, and a leveling agent. The content of other components based on the total amount of the p-type material may be, for example, 20 mass% or less, and is preferably 10 mass% or less, more preferably 5 mass% or less, and may be 1 mass% or less or 0 mass%.

### <p-type thermoelectric conversion layer>

The p-type thermoelectric conversion layer is a layer containing a p-type material. The content of the p-type material in the p-type thermoelectric conversion layer based on the total amount of the p-type thermoelectric conversion layer may be, for example, 80 mass% or more, and is preferably 90 mass% or more, more preferably 95 mass% or more, and may be 99 mass% or more, or 100 mass%.

The p-type thermoelectric conversion layer may further contain components other than the p-type material. Examples of components other than the p-type material include a residual solvent, a binder resin, a surfactant, an antifoaming agent, a coupling agent, an antioxidant, an ultraviolet absorber, a viscosity modifier, and a leveling agent. The content of other components based on the total amount of the p-type thermoelectric conversion layer may be, for example, 20 mass% or less, and is preferably 10 mass% or less, more preferably 5 mass% or less, and may be 1 mass% or less or 0 mass%.

In order to obtain appropriate electrical resistance and excellent flexibility, the thickness of the p-type thermoelectric conversion layer is preferably 100 nm to 1 mm, more preferably 200 nm to 800 µm, still more preferably 300 nm to 600 µm, and yet more preferably 1 to 500 µm. That is, the thickness of the p-type thermoelectric conversion layer may be, for example, 100 nm to 1 mm, 100 nm to 800 µm, 100 nm to 600 µm, 100 nm to 500 µm, 200 nm to 1 mm, 200 nm to 800 µm, 200 nm to 600 µm, 200 nm to 500 µm, 300 nm to 1 mm, 300 nm to 800 µm, 300 nm to 600 µm, 300 nm to 500 µm, 1 µm to 1 mm, 1 µm to 800 µm, 1 µm to 600 µm, or 1 µm to 500 µm.

The p-type thermoelectric conversion layer may be formed by, for example, applying a coating solution containing a p-type material and a solvent onto a support and removing the solvent. In addition, the p-type thermoelectric conversion layer may be formed by applying a coating solution containing a p-type material and a solvent onto a support, removing the solvent, and subjecting the formed p-type material layer to a solvent treatment.

The solvent is not particularly limited as long as it can dissolve the conductive resin and disperse the carbon nanotubes. Examples of solvents include water, alcohols (methanol, ethanol, etc.), amides (N,N-dimethylformamide, N,N-dimethylacetamide, N-methylpyrrolidone, etc.), ketones (acetone, methyl ethyl ketone, etc.), glycols (ethylene glycol, diethylene glycol, etc.), dimethyl sulfoxide, and acetonitrile. In consideration of environmental burden reduction and handling properties, the solvent is preferably one or more of water, methanol, and ethanol, and more preferably water. In consideration of dispersion of carbon nanotubes, the solvent is preferably one or more of N-methylpyrrolidone, N,N-dimethylformamide, and dimethyl sulfoxide.

The solid content concentration of the coating solution (for example, it may be the content of the p-type material or the total content of the carbon nanotubes and the conductive resin) is not particularly limited, and may be, for example, 0.1 mass% or more, and is preferably 0.2 mass% or more, and more preferably 0.3 mass% or more. In addition, the solid content concentration of the coating solution may be, for example, 10 mass% or less, and is preferably 7 mass% or less, and more preferably 5 mass% or less. That is, the solid content concentration of the coating solution may be, for example, 0.1 to 10 mass%, 0.1 to 7 mass%, 0.1 to 5 mass%, 0.2 to 10 mass%, 0.2 to 7 mass%, 0.2 to 5 mass%, 0.3 to 10 mass%, 0.3 to 7 mass%, or 0.3 to 5 mass%.

The solvent treatment may be performed, for example, according to a first process of impregnating the p-type material layer with a solvent and a second process of removing the solvent from the p-type material layer after the first process.

According to the solvent treatment, impurities such as low-molecular-weight components slightly mixed into the p-type material and metal ions are removed, the interaction between the carbon nanotubes and the conductive resin becomes strong, and thermoelectric conversion characteristics tend to be further improved. In addition, it is thought that, in the solvent treatment, the conductive resin in the p-type material flows and fills voids between the carbon nanotubes, and a more dense structure is formed.

The solvent is preferably a polar solvent. The dielectric constant of the solvent may be, for example, 10 or more, and is preferably 15 or more and more preferably 20 or more. The solvent may be a protic solvent or an aprotic solvent, and is preferably an aprotic solvent.

The boiling point of the solvent is preferably 70°C or higher, more preferably 90°C or higher, still more preferably 110°C or higher, and may be 150°C or higher. When a heat treatment is performed in the second process to be described below, if the boiling point of the solvent is high, the solvent does not volatilize in the initial stage of the heat treatment, and the effect of the heat treatment becomes more significant.

Examples of solvents include water (a dielectric constant of 78 and a boiling point of 100°C), acetonitrile, ethanol, ethylene glycol, dimethyl sulfoxide (DMSO, a dielectric constant of 49 and a boiling point of 189°C), N-methylpyrrolidone, N,N-dimethylformamide, and N,N-dimethylacetamide. The solvents may be used alone or two or more thereof may be used in combination.

The solvent used in the first process may be the same solvent for the coating solution or a different one, and is preferably a different one. When a solvent different from that for the coating solution is used as the solvent in the first process, it is possible to cause structural changes that do not occur when the p-type material layer is formed and the thermoelectric conversion performance tends to be further improved.

The second process may be, for example, a process of removing the solvent by natural drying or a process of removing the solvent by performing a heat treatment, a decompression treatment or the like.

The second process preferably includes a process of heating the p-type material layer impregnated with the solvent. It is thought that, in the heat treatment, the solvent, which has improved compatibility with the conductive resin, causes the conductive resin in the material to flow, and to fill voids between the carbon nanotubes, and a more dense structure is formed.

In the second process, the temperature during the heat treatment is not particularly limited, and may be, for example, 40°C or higher, and is preferably 50°C or higher and more preferably 60°C or higher. When the temperature during the heat treatment is increased, the Seebeck coefficient tends to be further improved. In addition, the temperature during the heat treatment may be, for example, 250°C or lower, and is preferably 225°C or lower and more preferably 200°C or lower. When the temperature during the heat treatment is lowered, the electrical conductivity tends to be further improved. That is, the Seebeck coefficient and electrical conductivity tend to fluctuate depending on the temperature during the heat treatment. Therefore, the temperature during the heat treatment may be appropriately selected from, for example, within the above range, taking into account the balance between the numerical values of the Seebeck coefficient and electrical conductivity. The heating temperature may be, for example, 40 to 250°C, 40 to 225°C, 40 to 200°C, 50 to 250°C, 50 to 225°C, 50 to 200°C, 60 to 250°C, 60 to 225°C, or 60 to 200°C.

The time for the heat treatment is not particularly limited. The time for the heat treatment may be, for example, 1 minute or longer, and is preferably 10 minutes or longer, and may be 12 hours or shorter, and is preferably 6 hours or shorter. That is, the time for the heat treatment may be, for example, 1 minute to 12 hours, 1 minute to 6 hours, 10 minutes to 12 hours, or 10 minutes to 6 hours.

Here, the heat treatment in the second process does not necessarily have to be aimed at removing the solvent, and the second process may be a process of additionally performing a treatment for removing the solvent after the heat treatment.

In a preferable aspect, the ratio (V₁/V₀) of the volume (V₁) of the p-type material layer after the solvent treatment to the volume (V₀) of the p-type material layer before the solvent treatment may be, for example, 0.6 or less, and is preferably 0.5 or less. In addition, the ratio (V₁/V₀) is, for example, 0.1 or more, and preferably 0.2 or more. That is, the solvent treatment may be, for example, a process of treating the p-type material with a solvent so that the ratio (V₁/V₀) is within the above range. Here, the ratio (V₁/V₀) can also be called a ratio of the thicknesses of the p-type material layer before and after the solvent treatment. The ratio (V₁/V₀) may be, for example, 0.1 to 0.6, 0.1 to 0.5, 0.2 to 0.6, or 0.2 to 0.5.

### <n-type material>

The n-type material is obtained by doping a p-type material containing carbon nanotubes and a conductive resin with a dopant. Examples of p-type materials include the same p-type materials included in the above p-type thermoelectric conversion layer. The p-type material for forming the n-type material preferably contains the same conductive resin as the p-type material of the p-type thermoelectric conversion layer, more preferably contains the same carbon nanotubes and the same conductive resin as the p-type material of the p-type thermoelectric conversion layer, and still more preferably has the same composition as the p-type material of the p-type thermoelectric conversion layer.

In this specification, a dopant is a substance that changes the Seebeck coefficient of a material to be doped with the dopant.

In this specification, "changing the Seebeck coefficient" means reducing the Seebeck coefficient value or changing the Seebeck coefficient value from a positive value to a negative value. A thermoelectric conversion material having a positive Seebeck coefficient value has p-type conductivity, and a thermoelectric conversion material having a negative Seebeck coefficient value contains an n-type material. The Seebeck coefficient can be measured by, for example, a measurement method to be described below, and the polarity of the thermoelectric conversion material can be determined from the positiveness or negativeness of the measured value.

### <Measurement of Seebeck coefficient>

A polyimide plate coated with a measurement target is cut out to 20 mm×10 mm, one end of the test piece is cooled (about 5°C), the other end is heated (about 5°C), the temperature difference and voltage occurring between both ends are measured with an alumel-chromel thermocouple, and the Seebeck coefficient is calculated from the temperature difference and voltage slope.

In the present embodiment, the dopant contains an anion that is a complex ion (hereinafter simply referred to as an "anion"), an alkali metal cation (hereinafter simply referred to as a "cation"), and a cation scavenger (hereinafter simply referred to as a "scavenger"). When a p-type material is doped with a dopant, the Seebeck coefficient of the p-type material changes, and an n-type material exhibiting n-type conductivity can be obtained. In addition, when the dopant contains the above specific component, excellent thermoelectric conversion performance is achieved.

The reason why the above effect is exhibited is not particularly limited, but one reason is considered to be that the scavenger contained in the dopant captures a cation to dissociate an anion, and the anion changes the carbon nanotube carrier from a hole to an electron. In this case, in the present embodiment, since the anion is a complex ion having a metal atom at the center, it is thought that the interaction between the metal atom and the carbon nanotube causes conversion into an n-type significantly, and since the complex ion has a large ion size, it has favorable dissociation with the cation captured by the scavenger, which is also considered to be one reason for the above effect.

In addition, since the anion of the dopant of the present embodiment is a complex ion, metal atoms derived from the complex ion remain in the n-type material. In the present embodiment, the metal atoms remaining in the n-type material function as an antioxidant, changes in physical properties over time are curbed and an effect of improved storage stability is also exhibited.

The anion that is a complex ion may be an anion selected from the group consisting of a ferrocyanide ion, ferricyanide ion, tetrachloroferrate(III) ion, tetrachloroferrate(II) ion, tetracyanonickelate(II) ion, tetrachloronickelate(II) ion, tetracyanocobalt(II) ion, tetrachlorocobalt(II) ion, tetracyanocuprate(III) ion, tetrachlorocuprate(II) ion, hexacyanochrome(III) ion, tetrahydroxozincate(II) ion and tetrahydroxide aluminate(III) ion. Among these, a ferrocyanide ion is preferable. When the anion is a ferrocyanide ion, an n-type material having better properties is obtained. In addition, when the anion is a ferrocyanide ion, iron atoms remaining in the n-type material suitably functions as an antioxidant, changes in physical properties over time are further curbed, and storage stability tends to be further improved.

The anion that is a complex ion may contain an iron atom, and for example, it is preferably selected from the group consisting of a ferrocyanide ion, a ferricyanide ion, a tetrachloroferrate(III) ion and a tetrachloroferrate(II) ion. The anion containing an iron atom is preferably a ferrocyanide ion because an n-type material having better properties is obtained. In addition, in consideration of the antioxidant effect, the content of iron atoms in the n-type material is preferably 0.001 mass% to 15 mass%, more preferably 0.005 mass% to 12 mass%, and still more preferably 0.01 mass% to 10 mass%. That is, the content of iron atoms in the n-type material may be, for example, 0.001 to 15 mass%, 0.001 to 12 mass%, 0.001 to 10 mass%, 0.005 to 15 mass%, 0.005 to 12 mass%, 0.005 to 10 mass%, 0.01 to 15 mass%, 0.01 to 12 mass%, or 0.01 to 10 mass%. Here, in this specification, the content of iron atoms indicates a value measured by scanning electron microscope (SEM)-energy dispersive X-ray spectroscopy (EDS).

The anion may be an anion generated when the complex salt dissociates in the dopant solution. Examples of complex salts include potassium ferrocyanide, sodium ferrocyanide, potassium ferricyanide, sodium ferricyanide, potassium tetrachloroferrate(III), sodium tetrachloroferrate(III), potassium tetrachloroferrate(II), and sodium tetrachloroferrate(II). The complex salt may be a hydrate.

Examples of alkali metal cations include sodium ions, potassium ions, and lithium ions.

The cation scavenger is not particularly limited as long as it is a substance that has an ability to capture a cation. Examples thereof include crown ether compounds, cyclodextrin, calixarene, ethylenedinitrilotetraacetic acid, porphyrin, phthalocyanine and their derivatives. In the organic solvent, it is preferable to use a crown ether compound.

Examples of crown ether compounds include 15-crown-5-ether, 18-crown-6-ether, 12-crown-4-ether, benzo-18-crown-6-ether, benzo-15-crown-5-ether, and benzo-12-crown-4-ether. The ring size of the crown ether used as a scavenger may be selected according to the size of the metal ion to be captured. For example, when the metal ion is a potassium ion, an 18-membered crown ether is preferable, when the metal ion is a sodium ion, a 15-membered crown ether is preferable, and when the metal ion is a lithium ion, a 12-membered crown ether is preferable.

A crown ether compound having a benzene ring in the molecule is preferable. When such a crown ether compound is used, p-type conversion due to oxidation is curbed, and storage stability tends to be further improved. Examples of crown ether compounds having a benzene ring include benzo-18-crown-6-ether, benzo-15-crown-5-ether, and benzo-12-crown-4-ether.

The molar ratio (C₂/C₁) of the content C₂ of the scavenger to the content C₁ of the cation may be, for example, 0.1 to 5, and is preferably 0.3 to 3, and more preferably 0.5 to 2. That is, the molar ratio (C₂/C₁) may be, for example, 0.1 to 5, 0.1 to 3, 0.1 to 2, 0.3 to 5, 0.3 to 3, 0.3 to 2, 0.5 to 5, 0.5 to 3, or 0.5 to 2.

The dopant may contain, as necessary, a substance other than the above anion, cation, and scavenger. Such a substance is not particularly limited as long as it does not inhibit the function of the dopant, and examples thereof include water and an organic solvent.

The dopant may contain a plurality of anions, cations, and scavengers.

The method for producing an n-type material may include a process of doping a p-type material with a dopant (n-type conversion process).

The method of doping a p-type material with a dopant in the n-type conversion process is not particularly limited, and for example, a method of bringing a p-type material into contact with a dopant solution containing a dopant may be exemplified.

In a preferable aspect, the n-type conversion process may include an impregnation process of impregnating at least a part of a p-type material with a dopant solution containing a dopant and a solvent, and a solvent removal process of removing the solvent from the material after impregnation with the dopant solution.

The boiling point of the solvent is preferably 70°C or higher, more preferably 90°C or higher, still more preferably 110°C or higher, and may be 150°C or higher. When a heat treatment is performed in the solvent removal process to be described below, if the boiling point of the solvent is high, most of the solvent is not removed in the initial stage of the heat treatment, and the effect of the heat treatment is sufficiently exhibited. When a solvent having the above suitable boiling point range is used, the effect of the heat treatment is more significantly exhibited.

Examples of solvents include water, acetonitrile, ethanol, ethylene glycol, dimethyl sulfoxide (DMSO), N-methylpyrrolidone, N,N-dimethylformamide, and N,N-dimethylacetamide. Here, the solvents may be used alone or two or more thereof may be used in combination.

The dopant solution may contain other components in addition to the dopant and the solvent as long as the effects of the present invention are not impaired. Examples of other components include a binder resin, an antioxidant, a thickener, and a surfactant.

The method of impregnating a p-type material with a dopant solution is not particularly limited, and for example, methods such as immersing a p-type material in a dopant solution and applying a p-type material to a dopant solution may be exemplified.

Since the dopant of the present embodiment has excellent doping efficiency, doping can be completed in a short time. The time for impregnating a p-type material with a dopant solution may be, for example, 10 minutes or longer. In addition, the time for impregnating a p-type material with a dopant solution may be, for example, 72 hours or shorter or 24 hours or shorter. When the time for impregnation with a dopant solution is within the above range, the productivity of the n-type material is excellent.

In the impregnation process, a material impregnated with the dopant solution is obtained, and this material is subjected to the solvent removal process. Here, in the solvent used in the impregnation process, a part that has not impregnated or adhered to the material may be removed in the final impregnation process. For example, when the p-type material is immersed in the dopant solution in the impregnation process, the material may be taken out of the dopant solution and subjected to the solvent removal process.

In the solvent removal process, at least a part of the solvent is removed from the material after impregnation with the above dopant solution. In the solvent removal process, it is not always necessary to remove the entire solvent, and the solvent may remain as long as the function of the n-type material is sufficiently performed.

The solvent removal process may be, for example, a process of removing the solvent by natural drying or a process of removing the solvent by performing a heat treatment, a decompression treatment or the like.

In a preferable aspect, the solvent removal process may include a process of heating the material impregnated with the solvent. In this aspect, it is thought that the solvent, which has improved compatibility with the conductive resin by heating, causes the conductive resin in the material to flow and fills voids between the carbon nanotubes, and a more dense structure is formed. Therefore, in this aspect, thermoelectric conversion characteristics tend to be more significantly improved.

In this aspect, the temperature during the heat treatment is not particularly limited, and may be, for example, 40°C or higher, and is preferably 50°C or higher and more preferably 60°C or higher. When the temperature during the heat treatment is increased, the Seebeck coefficient tends to be further improved. In addition, the temperature during the heat treatment may be, for example, 250°C or lower, and is preferably 225°C or lower and more preferably 200°C or lower. When the temperature during the heat treatment is lowered, the electrical conductivity tends to be further improved. That is, the heat treatment temperature may be, for example, 40 to 250°C, 40 to 225°C, 40 to 200°C, 50 to 250°C, 50 to 225°C, 50 to 200°C, 60 to 250°C, 60 to 225°C, or 60 to 200°C. In this aspect, the Seebeck coefficient and electrical conductivity tend to fluctuate depending on the temperature during the heat treatment. Therefore, the temperature during the heat treatment may be appropriately selected from, for example, within the above range, taking into account the balance between the numerical values of the Seebeck coefficient and electrical conductivity.

In this aspect, the time for the heat treatment is not particularly limited. The time for the heat treatment may be, for example, 1 minute or longer, and is preferably 10 minutes or longer, and may be 12 hours or shorter, and is preferably 6 hours or shorter. That is, the time for the heat treatment may be, for example, 1 minute to 12 hours, 1 minute to 6 hours, 10 minutes to 12 hours, or 10 minutes to 6 hours.

Here, the heat treatment in this aspect does not necessarily have to be aimed at removing the solvent, and the solvent removal process according to this aspect may be a process of additionally performing a treatment for removing the solvent after the heat treatment.

In the present embodiment, a part of the p-type material doped with a dopant becomes the n-type material. In the present embodiment, all of the p-type material may be doped with a dopant to form an n-type material, or a part of the p-type material may be doped with a dopant to form a composite of the p-type material and the n-type material.

### <n-type thermoelectric conversion layer>

The n-type thermoelectric conversion layer is a layer containing an n-type material. The content of the n-type material in the n-type thermoelectric conversion layer based on the total amount of the n-type thermoelectric conversion layer may be, for example, 80 mass% or more, and is preferably 90 mass% or more, more preferably 95 mass% or more, and may be 99 mass% or more, or 100 mass%.

The n-type thermoelectric conversion layer may further contain components other than the n-type material. Examples of components other than the n-type material include a residual solvent, a binder resin, a surfactant, an antifoaming agent, a coupling agent, an antioxidant, an ultraviolet absorber, a viscosity modifier, and a leveling agent. The content of other components based on the total amount of the n-type thermoelectric conversion layer may be, for example, 20 mass% or less, and is preferably 10 mass% or less, more preferably 5 mass% or less, and may be 1 mass% or less or 0 mass%.

In order to obtain appropriate electrical resistance and excellent flexibility, the thickness of the n-type thermoelectric conversion layer is preferably 100 nm to 1 mm, more preferably 200 nm to 800 µm, still more preferably 300 nm to 600 µm, and yet more preferably 1 to 500 µm. That is, the thickness of the n-type thermoelectric conversion layer may be, for example, 100 nm to 1 mm, 100 nm to 800 µm, 100 nm to 600 µm, 100 nm to 500 µm, 200 nm to 1 mm, 200 nm to 800 µm, 200 nm to 600 µm, 200 nm to 500 µm, 300 nm to 1 mm, 300 nm to 800 µm, 300 nm to 600 µm, 300 nm to 500 µm, 1 µm to 1 mm, 1 µm to 800 µm, 1 µm to 600 µm or 1 µm to 500 µm.

The n-type thermoelectric conversion layer can be formed, for example, by applying a coating solution containing a p-type material and a solvent onto a support, removing the solvent to form a p-type material layer, and doping the p-type material layer with a dopant. In addition, the n-type thermoelectric conversion layer can be formed by applying a coating solution containing a p-type material and a solvent onto a support, removing the solvent to form a p-type material layer, subjecting the p-type material layer to a solvent treatment, and doping the p-type material layer after the solvent treatment with a dopant.

### <Thermoelectric conversion element>

The thermoelectric conversion element of the present embodiment includes a p-type thermoelectric conversion layer and an n-type thermoelectric conversion layer that is in contact with the p-type thermoelectric conversion layer.

In the thermoelectric conversion element of the present embodiment, the p-type thermoelectric conversion layer and the n-type thermoelectric conversion layer may be arranged on a support. Examples of supports include polyimide, polyethylene terephthalate, polyethylene naphthalate, polyethylene isophthalate, polybutylene terephthalate, polycarbonate, polyetheretherketone, polyphenyl sulfide, polysulfone, glass, copper, silver, gold, and aluminum. Among these, it is preferably selected from the group consisting of polyimide, polyethylene terephthalate and polyethylene naphthalate because these exhibit favorable flexibility.

In the thermoelectric conversion element of the present embodiment, the p-type thermoelectric conversion layer and the n-type thermoelectric conversion layer may be laminated in the thickness direction or may be arranged adjacent to each other in the in-plane direction. In addition, the p-type thermoelectric conversion layer and the n-type thermoelectric conversion layer may be arranged so that they partially overlap.

The thermoelectric conversion element of the present embodiment may include a plurality of p-type thermoelectric conversion layers and a plurality of n-type thermoelectric conversion layers.

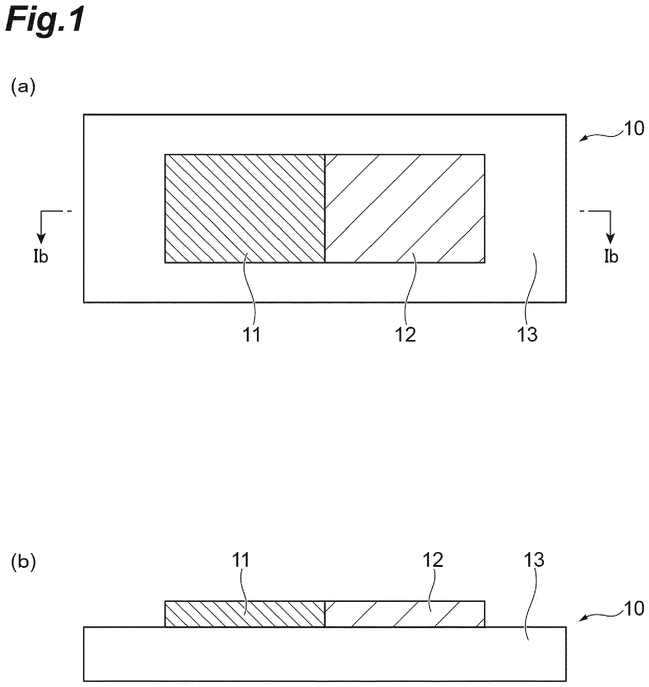

FIG. 1(a) is a top view showing one aspect of a thermoelectric conversion element, and FIG. 1(b) is a cross-sectional view showing the Ib-Ib cross section in FIG. 1(a). A thermoelectric conversion element 10 shown in FIG. 1(a) and FIG. 1(b) includes a p-type thermoelectric conversion layer 11 and an n-type thermoelectric conversion layer 12. The p-type thermoelectric conversion layer 11 and the n-type thermoelectric conversion layer 12 are arranged adjacent to each other on a support 13.

The thermoelectric conversion element 10 can be produced, for example, by forming a p-type material layer on the support 13 and doping a part of the layer with a dopant. A part of the layer (a part doped with a dopant) becomes the n-type thermoelectric conversion layer 12, and another part (a part not doped with a dopant) is used as the p-type thermoelectric conversion layer 11.

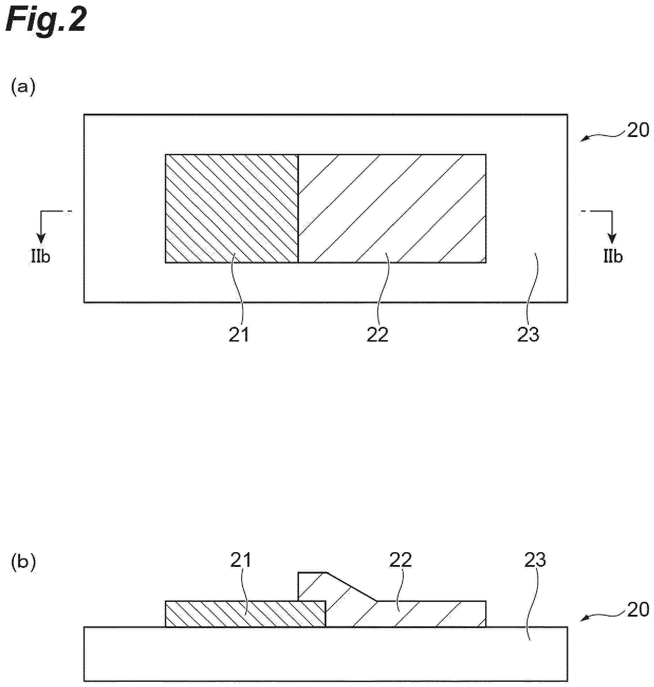

FIG. 2(a) is a top view showing another aspect of the thermoelectric conversion element, and FIG. 2(b) is a cross-sectional view showing the IIb-IIb cross section in FIG. 2(a). A thermoelectric conversion element 20 shown in FIG. 2(a) and FIG. 2(b) includes a p-type thermoelectric conversion layer 21 and an n-type thermoelectric conversion layer 22. The p-type thermoelectric conversion layer 21 and the n-type thermoelectric conversion layer 22 are arranged on a support 23 so that a part of the n-type thermoelectric conversion layer 22 overlaps the p-type thermoelectric conversion layer 21.

The thermoelectric conversion element 20 can be produced, for example, by forming the p-type thermoelectric conversion layer 21 on the support 23, and then forming the n-type thermoelectric conversion layer 22 so that it overlaps the p-type thermoelectric conversion layer 21.

The thermoelectric conversion element of the present embodiment may further include members other than the p-type thermoelectric conversion layer and the n-type thermoelectric conversion layer.

The thermoelectric conversion element of the present embodiment may further include, for example, a first conductive substrate electrically connected to the side of the p-type thermoelectric conversion layer and a second conductive substrate electrically connected to the side of the n-type thermoelectric conversion layer. The first conductive substrate and the second conductive substrate can also be referred to as a first electrode and a second electrode, respectively.

In addition, the thermoelectric conversion element of the present embodiment may further contain a sealing material for sealing the thermoelectric conversion material, a wiring for electrically connecting the thermoelectric conversion elements or extracting power to an external circuit, an insulation material or thermally conductive material for controlling thermal conductivity of the thermoelectric conversion element, and the like.

In the thermoelectric conversion element of the present embodiment, members other than the p-type thermoelectric conversion layer and the n-type thermoelectric conversion layer may be, for example, the same as those of known thermoelectric conversion elements. That is, the thermoelectric conversion element of the present embodiment may be one in which the p-type thermoelectric conversion layer and the n-type thermoelectric conversion layer in the known thermoelectric conversion element are replaced with the above p-type thermoelectric conversion layer and n-type thermoelectric conversion layer, respectively.

### (Method for producing thermoelectric conversion element)

The method for producing a thermoelectric conversion element of the present embodiment includes a process of doping a part of the p-type material layer containing a p-type material containing carbon nanotubes and a conductive resin with a dopant (n-type conversion process). In the p-type material layer, a part doped with a dopant becomes an n-type thermoelectric conversion layer, and another part (a part not doped with a dopant) becomes a p-type thermoelectric conversion layer.

The n-type conversion process may include an impregnation process of impregnating a part of the p-type material layer with a dopant solution containing a dopant and a solvent, and a solvent removal process of removing at least a part of the solvent.

The p-type material, the dopant, the n-type conversion process, the impregnation process and the solvent removal process may be the same as the above p-type material, dopant, n-type conversion process, impregnation process and solvent removal process.

According to the method for producing a thermoelectric conversion element of the present embodiment, the above thermoelectric conversion element (particularly, the thermoelectric conversion element 10 shown in FIG. 1(a)) can be produced efficiently.

While preferable embodiments of the present invention have been described above, the present invention is not limited to the embodiments.

### [Examples]

Hereinafter, the present invention will be described in more detail with reference to examples, but the present invention is not limited to these examples.

### [Example 1]

### (Preparation of coating solution)

A single-walled CNT aqueous dispersion (a single-walled CNT G/D ratio of 41, and a diameter of 0.9 to 1.7 nm) with a single-walled CNT concentration of 0.4 mass% was prepared. 0.56 g of "Clevios PH1000" (PEDOT/PSS aqueous dispersion, solid content concentration: 1.2 mass%, commercially available from Heraeus) and 5 g of the single-walled CNT aqueous dispersion were mixed, and the mixture was subjected to a stirring treatment (treatment time: 10 minutes) at a stirring temperature of 30°C using a rotation/revolution mixer ("Thinky Mixer ARE-310" commercially available from Thinky Corporation) to prepare a coating solution.

### (Formation of p-type material layer)

A polyimide film (thickness: 100 µm) was attached to a stainless steel plate with a thickness of 500 µm, and additionally, a region with a width of 10 mm and a length of 60 mm was formed on the polyimide film using a masking tape. The coating solution was applied using a doctor blade so that the thickness was 2.8 mm and dried at 60°C for 2 hours. After drying, the masking tape was peeled off to obtain a p-type material layer with a width of 10 mm and a length of 60 mm.

### (Solvent treatment)

The p-type material layer obtained above was immersed in dimethyl sulfoxide (DMSO) as a solvent at room temperature (25°C) for 5 minutes. Then, a heat drying treatment was performed at 60°C for 120 minutes to produce a p-type thermoelectric conversion layer. The thickness of the p-type thermoelectric conversion layer was 15 µm, and V₁/V₀ was 0.1.

### (Preparation of dopant solution)

0.106 g of potassium ferrocyanide trihyrate and 0.312 g of benzo-18-crown-6-ether were dissolved in 5 mL of ultrapure water (the concentrations of potassium ions and benzo-18 crown-6-ether were each 0.2 M) to prepare a dopant solution.

### (Doping treatment)

120 µL of the dopant solution was added dropwise to a partial region (width 10 mm×length30 mm) of the obtained p-type thermoelectric conversion layer. Then, the sample was heated and dried at 60°C for 30 minutes, and then heated at 100°C for 60 minutes, and a part of the p-type thermoelectric conversion layer was converted into an n-type to obtain a thermoelectric conversion element 1.

### [Example 2]

### (Formation of p-type thermoelectric conversion layer)

A p-type thermoelectric conversion layer was obtained in the same operation as in Example 1 except that the coating region of the coating solution was changed to a width of 10 mm and a length of 31 mm.

### (Formation of n-type thermoelectric conversion layer)

The same coating solution as in Example 1 was applied to a region with a width of 10 mm and a length of 31 mm so that it overlapped 1 mm of the end of the p-type thermoelectric conversion layer in the length direction to form a p-type material layer. Next, the p-type material layer was immersed in DMSO for 30 minutes, and then heated and dried at 60°C for 120 minutes. Next, 124 µL of the same dopant solution as in Example 1 was added dropwise to the p-type material layer, then heated and dried at 60°C for 30 minutes, and then heated at 100°C for 60 minutes to form an n-type thermoelectric conversion layer. Thereby, a thermoelectric conversion element 2 was obtained.

### [Example 3]

A thermoelectric conversion element 3 was obtained in the same operation as in Example 1 except that, when the coating solution was prepared, the amount of the PEDOT/PSS dispersion was changed to 0.087 g.

### [Example 4]

A thermoelectric conversion element 3 was obtained in the same operation as in Example 1 except that, when the coating solution was prepared, the amount of the PEDOT/PSS dispersion was changed to 1.667 g.

### [Example 5]

A thermoelectric conversion element 5 was obtained in the same operation as in Example 1 except that, when the dopant solution was prepared, 0.121 g of sodium ferrocyanide decahydrate was used in place of potassium ferrocyanide trihyrate, and 0.268 g of benzo-15-crown-5-ether was used in place of benzo-18-crown-6-ether.

### [Comparative Example 1]

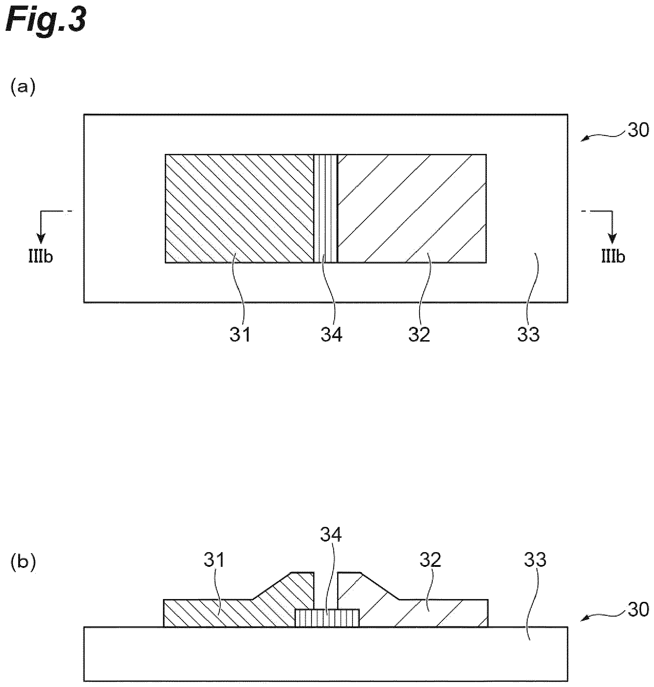

As Comparative Example 1, a thermoelectric conversion element shown in FIG. 3(a) and FIG. 3(b) was produced. FIG. 3(a) is a top view showing the thermoelectric conversion element of Comparative Example 1, and FIG. 3(b) is a cross-sectional view showing the IIIb-IIIb cross section in FIG. 3(a). In a thermoelectric conversion element 30 shown in FIG. 3(a) and FIG. 3(b), a p-type thermoelectric conversion layer 31 and an n-type thermoelectric conversion layer 32 were arranged apart from each other on a support 33, and the p-type thermoelectric conversion layer 31 and the n-type thermoelectric conversion layer 32 were electrically connected by an electrode 34.

### (Formation of gold electrode)

A copper tape with a width of 10 mm and a length of 2 mm (commercially available from Teraoka Seisakusho Co., Ltd.) was attached onto a polyimide film. After the copper surface was plated with nickel, the surface was additionally plated with gold to form a gold electrode.

### (Formation of p-type thermoelectric conversion layer)

A masking tape with a width of 1 mm was attached to the center of the gold electrode. Next, a region with a width of 1 mm and a length of 31 mm was formed on the polyimide film using a masking tape so that the center of the region and the center of the gold electrode were aligned. The coating solution prepared in the same manner as in Example 1 was applied to this region, and dried, and the masking tape was peeled off. Next, the solvent treatment was performed in the same manner as in Example 1 to obtain a p-type thermoelectric conversion layer formed into two parts via the gold electrode.

### (Formation of n-type thermoelectric conversion layer)

120 µL of the dopant solution prepared in the same manner as in Example 1 was added dropwise to one of the two p-type thermoelectric conversion layers, then heated and dried at 60°C for 30 minutes, and then heated at 100°C for 60 minutes to obtain a thermoelectric conversion element 6.

### [Comparative Example 2]

### (Formation of p-type thermoelectric conversion layer)

A p-type thermoelectric conversion layer was obtained in the same operation as in Example 1 except that the coating region of the coating solution was changed to a width of 10 mm and a length of 31 mm.

### (Formation of n-type thermoelectric conversion layer)

2.9 g of titanium disulfide (commercially available from Kojundo Chemical Lab. Co., Ltd.) and 3.9 g of polyvinylidene fluoride in an N-methyl-2-pyrrolidone solution (a resin concentration of 4 mass%) were mixed and subjected to a stirring treatment (treatment time: 10 minutes) at a stirring temperature of 30°C using a rotation/revolution mixer ("Thinky Mixer ARE-310" commercially available from Thinky Corporation) to prepare a titanium disulfide dispersion. Next, a titanium disulfide dispersion was applied to a region with a width of 10 mm×a length of 31 mm so that it overlapped 1 mm of the end of the p-type thermoelectric conversion layer in the length direction, and heated at 80°C for 120 minutes, and the solvent was removed to form an n-type thermoelectric conversion layer. Thereby, a thermoelectric conversion element 7 was obtained.

### (Evaluation of element resistance)

Probes 1 and 2 were brought into contact with each of the thermoelectric conversion elements 1 to 7 at positions of 2 mm from both ends, and probes 3 and 4 were brought into contact with the elements at positions of 5 mm from both ends. While sweeping a current flowing between the probes 1 and 2 between -10 mA and 10 mA, the voltage between the probes 3 and 4 was measured, and the resistance of the element was calculate from the obtained linear current-voltage slope. The results are shown in Table 1.

Here, in Table 1, the element resistance value is a relative value based on the element resistance of 100 in Example 1. In addition, in Table 1, the items "CNT" and "conductive resin" indicate content proportions of the components in the p-type material. In addition, in Table 1, the item "dopant" indicates the type of the dopant used, with A for the dopant used in Example 1 and B for the dopant used in Example 5. In addition, in Table 1, the item "element configuration" indicates the configuration of a corresponding element, with 10 for the thermoelectric conversion element 10 in FIG. 1, 20 for the thermoelectric conversion element 20 in FIG. 2, and 30 for the thermoelectric conversion element 30 in FIG. 3.

**[Table 1]**

| | | Example | | | | | Comparative Example | |
|---|---|---|---|---|---|---|---|---|
| | | 1 | 2 | 3 | 4 | 5 | 1 | 2 |
| Thermoelectric conversion element | | 1 | 2 | 3 | 4 | 5 | 6 | 7 |
| p-type material (parts by mass) | CNT | 75 | 75 | 95 | 50 | 75 | 75 | 75 |
| | Conductive resin | 25 | 25 | 5 | 50 | 25 | 25 | 25 |
| n-type material | Dopant | A | A | A | A | B | A | - |
| Element configuration | | 10 | 20 | 10 | 10 | 10 | 30 | 20 |
| Element resistance | | 100 | 103 | 105 | 103 | 103 | 121 | 43788 |

As shown in Table 1, it was confirmed that the thermoelectric conversion elements of the examples were thermoelectric conversion elements with a low element resistance and a high output.

### Reference Signs List

10, 20, 30 Thermoelectric conversion element
11, 21, 31 p-type thermoelectric conversion layer
12, 22, 32 n-type thermoelectric conversion layer
13, 23, 33 Support
34 Electrode

## Claims

1. A thermoelectric conversion element having:
a p-type thermoelectric conversion layer containing a p-type material containing carbon nanotubes and a conductive resin; and
an n-type thermoelectric conversion layer that is in contact with the p-type thermoelectric conversion layer and contains an n-type material obtained by doping the p-type material containing carbon nanotubes and a conductive resin with a dopant,
wherein the dopant contains an anion that is a complex ion, an alkali metal cation, and a cation scavenger.

2. The thermoelectric conversion element according to claim 1,
wherein the anion is selected from the group consisting of a ferrocyanide ion, ferricyanide ion, a tetrachloroferrate(III) ion and a tetrachloroferrate(II) ion.

3. The thermoelectric conversion element according to claim 1,
wherein the cation scavenger is a crown ether compound.

4. The thermoelectric conversion element according to claim 1,
wherein the cation scavenger is a crown ether compound having a benzene ring in the molecule.

5. The thermoelectric conversion element according to claim 1,
wherein the conductive resin is composed of poly(3,4-ethylenedioxythiophene) and an electron acceptor.

6. The thermoelectric conversion element according to any one of claims 1 to 5,
wherein the p-type thermoelectric conversion layer and the n-type thermoelectric conversion layer have a thickness of 1 to 500 µm.

7. A method for producing a thermoelectric conversion element having a p-type thermoelectric conversion layer and an n-type thermoelectric conversion layer, comprising
a process of doping a part of a p-type material layer containing a p-type material containing carbon nanotubes and a conductive resin with a dopant,
wherein the p-type thermoelectric conversion layer contains the p-type material,
wherein the n-type thermoelectric conversion layer contains an n-type material obtained by doping the p-type material with the dopant, and
wherein the dopant contains an anion that is a complex ion, an alkali metal cation, and a cation scavenger.

8. The method according to claim 7,
wherein the process includes
an impregnation process of impregnating a part of the p-type material layer with a dopant solution containing the dopant and a solvent, and
a solvent removal process of removing at least a part of the solvent.
